# EUROPEAN PATENT SPECIFICATION

(11) **EP 2 713 410 B1**
(45) Date of publication and mention of the grant of the patent: **02.05.2018**
(21) Application number: 13020107.2
(22) Date of filing: 24.09.2013
(51) Int. Cl.: H01L 33/50, F21S 8/10

(54) **Light emitting device**
Lichtemittierende Vorrichtung
Dispositif électroluminescent

(30) Priority: 27.09.2012 JP 2012213859
(43) Date of publication of application: 02.04.2014
(73) Proprietor: Stanley Electric Co., Ltd., Meguro-ku Tokyo 153 (JP)
(72) Inventor: Nakazato, Yoshiaki, Tokyo, 153-8636 (JP)
(74) Representative: Klang, Alexander H.

(56) References cited:
- EP-A1- 1 734 302
- EP-A2- 2 461 090
- JP-A- 2009 170 723
- JP-A- 2010 165 834
- US-A1- 2011 141 763
- US-A1- 2011 157 865
- US-A1- 2012 106 178

## Description

### Technical Field

The present invention relates to a light emitting device, and in particular, to a light emitting device with a structure utilizing a semiconductor light emitting element (for example, a semiconductor laser light source) and a wavelength conversion member (for example, phosphor) in combination.

### Background Art

Light emitting devices with a structure utilizing a semiconductor laser light source and a phosphor in combination have been conventionally proposed, as described in, for example, JP 2010-165834 A.

As shown in Fig. 1, the light emitting device 200 described in JP 2010-165834 A can include a semiconductor laser light source 210, a phosphor 220 disposed apart from the semiconductor laser light source 210, a condenser lens 230 disposed between the semiconductor laser light source 210 and the phosphor 220, and a holder 240 configured to hold the semiconductor laser light source 210, the phosphor 220, and the condenser lens 230.

The light emitting device 200 described in JP 2010-165834 A can be configured such that the semiconductor laser light source 210 can emit laser light, and the laser light can be collected by the condenser lens 230 to pass through the through hole of the holder 240 and be projected on the phosphor 220 disposed above the through hole just like a spot light. The phosphor 220 irradiated with the laser light can emit light as a result of excitation by the laser light, whereby the laser light having passed through the phosphor 220 and the emitted light by the excitation are mixed and projected from the light emitting device 200.

In general, the laser light from such a semiconductor laser light source can have a higher light density than the light from a light emitting diode. Therefore, if the high light density laser light is collected by the condenser lens 230 and irradiated onto the phosphor 220 in a spotlight manner, local brightness saturation or temperature quenching (also called as "thermal quenching") can occur, thereby decreasing the efficiency.

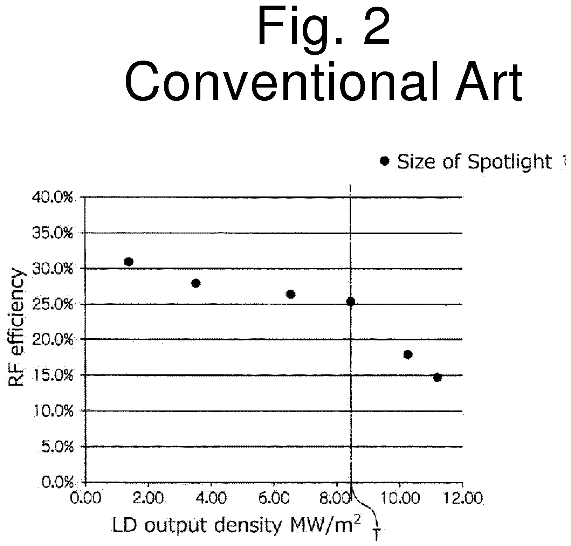

Fig. 2 is a graph describing this matter, in which RF efficiency (percentage of the light source output to the excitation output) is shown when the laser light that is emitted from a semiconductor laser light source and collected by a condenser lens is irradiated onto one face of a phosphor in a spotlight manner while varying the excitation density. In this experiment, the phosphor used is made of a disc-shaped ceramic with a diameter φ of 4 mm, and the spot size of laser light collected by the condenser lens is adjusted to be oval with a long axis of about 100 µm and a short axis of about 20 to 30 µm.

With reference to Fig. 2, the smaller the excitation density (LD output density) is, the higher the RF efficiency is. When the excitation density exceeds a certain value (threshold T), it can be seen that the RF efficiency abruptly decreases. This may be because when the excitation density is large, brightness saturation of the phosphor may occur, thereby lowering the efficiency. In addition to this, since the generated heat may increase, temperature quenching may occur to lower the efficiency. Namely, when the excitation density exceeds a certain value (threshold T), the deterioration of the light emission efficiency of the phosphor will be accelerated due to the increase in heat energy by the lowering of the light emission efficiency of the phosphor. Note that the threshold T for the lowering of RF efficiency due to the excitation density and for the abrupt lowering of RF efficiency may vary depending on the kind of the material of the phosphor and the heat dissipation of the phosphor.

The term "brightness saturation" refers to the phenomenon in which, when the energy density of laser light from a semiconductor laser light source exceeds a predetermined value, the fluorescence intensity does not rise in proportion to the increase of the energy density of the laser light. The term "temperature quenching" refers to the phenomenon in which, when a high energy density light source such as a semiconductor laser light source is used to excite a phosphor, the heat generated by the laser light from the light source decreases the light emission efficiency of the phosphor itself. (Refer to JP 2012-114040 A, for example.)

US 2011/0157865 A1 discloses an illumination device.

EP 2 461 090 A2 discloses that a vehicle light can prevent color variations of the projected image. The vehicle light can include a laser diode, a wavelength conversion member including a phosphor configured to receive blue light emitted from the laser diode and then emitting white light, a projection lens configured to project the white light emitted from the wavelength conversion member to provide forward illumination for a vehicle, and a diffusing portion provided to the projection lens, configured to diffuse the excitation light which is incident on the projection lens from the wavelength conversion member.

JP 2009 170723 A discloses a light-emitting device including: a base having a recess having an underside and an inner wall; a semiconductor laser element provided inside the recess; a diffusion member provided inside the recess for diffusing a light of a semiconductor laser element; and a wavelength converting member for absorbing the light of the semiconductor laser element to convert it into a light of a different wavelength. The semiconductor laser element is disposed so that an optical axis directs to the inner wall of the recess, the diffusion member is disposed on the optical axis of the semiconductor laser element, and the wavelength converting member is disposed to an opening direction of the recess.

EP 1 734 302 A1 discloses a light emitting device, comprising at least a light emitting element, a wavelength conversion member for converting the wavelength of light from the light emitting element, a bendable light guide member for guiding light from the light emitting element to the wavelength conversion member, and a heat conduction member that is thermally connected to the wavelength conversion member.

US 2011/141763 A1 discloses a lighting apparatus which emits light of a desired wavelength by irradiating excitation light from a light source to a wavelength converting member, wherein a structure is such that a part of wavelength-converted light which is launched from the wavelength converting member is made to launch from an irradiated-light emerging area without making the light incidence again to the wavelength converting member.

US 2012/0106178 A1 discloses a light emitting device including a light-emitting section for generating fluorescence by receiving a laser beam, and a light irradiation unit for irradiating a light irradiated surface of the light emitting section with a laser beam that increases regularly in beam diameter in a direction in which the laser beam travels.

### Summary

The present invention was devised in view of these and other problems and features in association with the conventional art. According to an aspect of the present invention, there is provided a light emitting device that can project high density laser light by collecting laser light to form light in a spotlight manner while remedying local brightness saturation and temperature quenching, and can suppress the lowering of efficiency due to such local brightness saturation and temperature quenching.

A light emitting device according to the present invention is provided as set forth in claim 1.

According to the above-described aspect of the present invention, the following advantageous effects can be provided.

First, the light emitting device can project high density laser light by collecting laser light with the optical system to form spot light while the device can remedy locally occurring brightness saturation and temperature quenching, and can suppress the lowering of efficiency due to such local brightness saturation and temperature quenching. This may be because the excitation light from the excitation light source can be incident on the wavelength conversion layer not as spot light collected by the optical system as in the conventional example, but as diffused light diffused by the diffusion layer with the brightness distribution having no local peak.

Second, possible color unevenness may be suppressed or prevented. This is also because the excitation light from the excitation light source can be incident on the wavelength conversion layer not as spot light collected by the optical system as in the conventional example, but as diffused light diffused by the diffusion layer with the brightness distribution having no local peak.

Third, the light extraction efficiency can be improved or high efficiency can be achieved. This is because the diffusion layer can suppress or prevent the color unevenness, and thus the thinning of the wavelength conversion layer can be achieved. If the color unevenness is tried to be suppressed or prevented by diffusing the excitation light from the excitation light source without any diffusion layer, the thickness of the wavelength conversion layer should be a certain thickness. This may result in deterioration of the light extraction efficiency due to the diffusion of emitted light within the wavelength conversion layer.

The light emitting device with the above configuration can further include a first reflection member configured to cover an area of the first face that is not irradiated with the excitation light that is emitted from the excitation light source and collected by the optical system.

With the above configuration, the light extraction efficiency can be further improved. This is because the light directing to the first face of the diffusion layer can be reflected by the first reflection member and can re-enter the diffusion layer.

In the light emitting device with any of the above configurations, the side faces of the wavelength conversion member can be covered with a second reflection member.

With the above configuration, the light extraction efficiency of the light emitting device can be further improved. This is because the side faces of the diffusion layer and the wavelength conversion layer of the wavelength conversion member can be covered with the second reflection member, and thus the light that is to exit from the side faces can be reflected by the second reflection member to re-enter the wavelength conversion member.

In the light emitting device with any of the above configurations, the optical system, which is configured to collect the excitation light from the excitation light source to irradiate the first face with the collected excitation light in a spotlight manner, can be an optical system having a condenser lens configured to collect the excitation light from the excitation light source to irradiate the center of the first face with the collected excitation light in a spotlight manner. Alternatively, the optical system can be an optical system having a condenser lens configured to collect the excitation light from the excitation light source and a light guide configured to guide the excitation light collected by the condenser lens to irradiate the center of the first face with the collected excitation light in a spotlight manner.

According another aspect of the present invention, a vehicle lighting device is provided as set forth in claim 6.

Preferred embodiments of the present invention may be gathered from the dependent claims.

### Brief Description of Drawings

These and other characteristics, features, and advantages of the present invention will become clear from the following description with reference to the accompanying drawings, wherein:

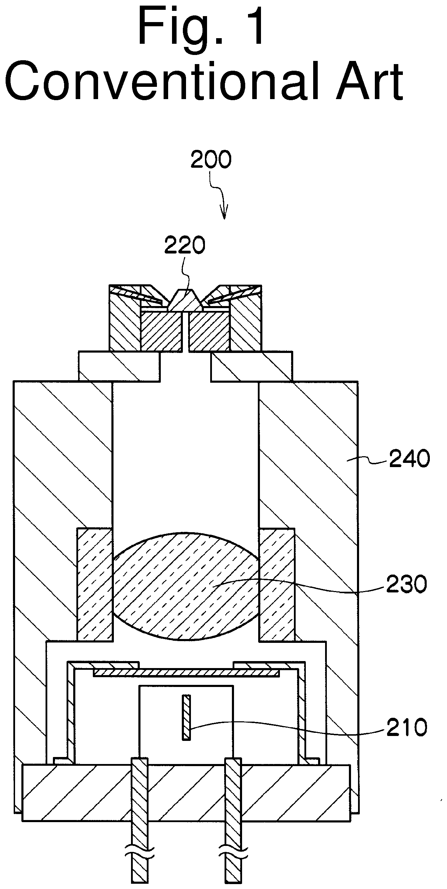

Fig. 1 is a cross-sectional view of a conventional light emitting device;
Fig. 2 is a graph showing an RF efficiency (percentage of the light source output to the excitation output) when the laser light that is emitted from a semiconductor laser light source and collected by a condenser lens is irradiated onto one face of a phosphor in a spotlight manner while varying the excitation density;
Fig. 3 is a cross-sectional view of a light emitting device 10 cut along a vertical plane including its optical axis AX₁₀ (center axis);
Fig. 4 is an enlarged view showing an area near a through hole 28;
Fig. 5 is an enlarged view showing an area near a through hole 28 according to a modification;
Figs. 6A, 6B, and 6C are each a brightness distribution of diffused light exiting through the upper face 30b of a diffusion layer 30 (being a diffusion plate) when the center of a lower face 30a of the diffusion layer 30 with a different thickness h is irradiated with the equivalent excitation light collected by a condenser lens 16 in a spotlight manner;
Fig. 7 is a cross-sectional view of a light emitting device 10 according to a modification;
Fig. 8 is sectional view showing a configuration example of a direct projection type vehicle lighting unit 50 including a projection lens 52 serving as an optical system configured to illuminate a front area of a vehicle body with light; and
Fig. 9 is a sectional view of a projector type vehicle lighting unit 60 including a reflection face 62, a shade 64 and a projection lens 66 which can constitute an optical system configured to illuminate a front area of a vehicle body with light.

### Description of Exemplary Embodiments

A description will now be made below to light emitting devices of the present invention with reference to the accompanying drawings in accordance with exemplary embodiments.

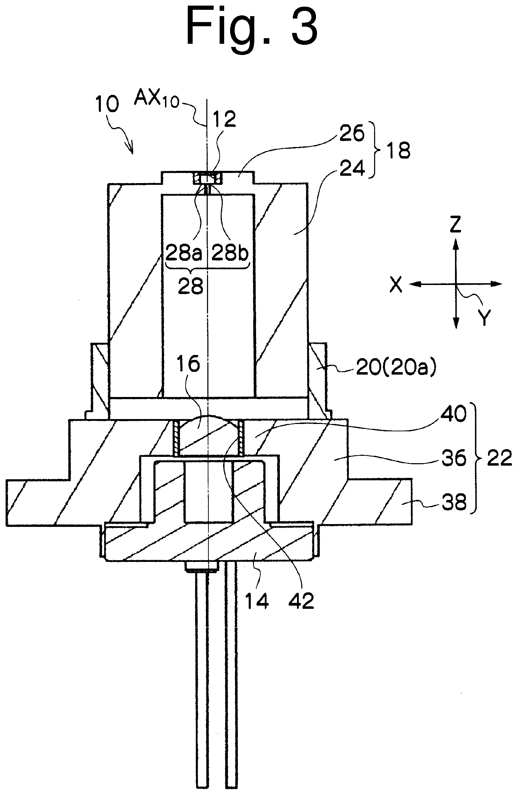

Fig. 3 is a cross-sectional view of a light emitting device 10 cut along a vertical plane including its optical axis AX₁₀ (center axis) .

As shown in Fig. 3, the light emitting device 10 can include a wavelength converting member 12 including a diffusion layer 30 and a wavelength conversion layer 32, an excitation light source 14, a condenser lens 16, a holder configured to hold these components, the holder including a first holder 18, a second holder 20, and a third holder 22, etc.

The first holder 18 can include a metal cylindrical tube portion 24 (made of stainless steel or aluminum, for example) configured to hold the wavelength conversion member 12 and have an upper opening end, and an upper face 26 configured to close the upper opening end. A through hole 28 can be formed at the center of the upper face 26 to penetrate the holder in the thickness direction thereof.

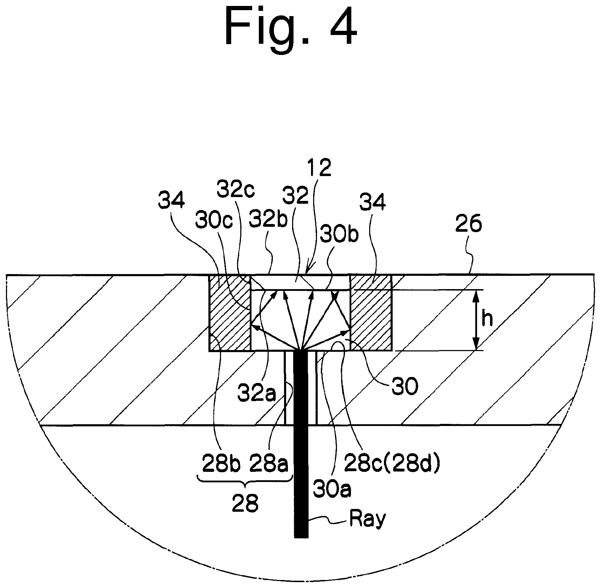

Fig. 4 is an enlarged view showing an area near the through hole 28.

As shown in Fig. 4, the through hole 28 can be configured to allow the excitation light Ray emitted from the excitation light source 14 and collected by the condenser lens 16 to pass therethrough. The through hole 28 can include a small diameter portion 28a on the side closer to the condenser lens 16 and a large diameter portion 28b opposite thereto. The portion between the small diameter portion 28a and the large diameter portion 28b can be a step portion 28c. A reflection film 28d made of Ag or Al can be formed on the step portion 28c. The reflection film 28d can serve to reflect light generated by the wavelength conversion member 12 or diffused light directed downward to cause the light to re-enter the diffusion layer 30.

The small diameter portion 28a can be a through hole having a circular cross section (φ: about 0.1 mm to about 0.3 mm), for example. Note that the small diameter portion 28a is not limited to a through hole having a circular cross section, but may be a through hole having a rectangular or oval cross section.

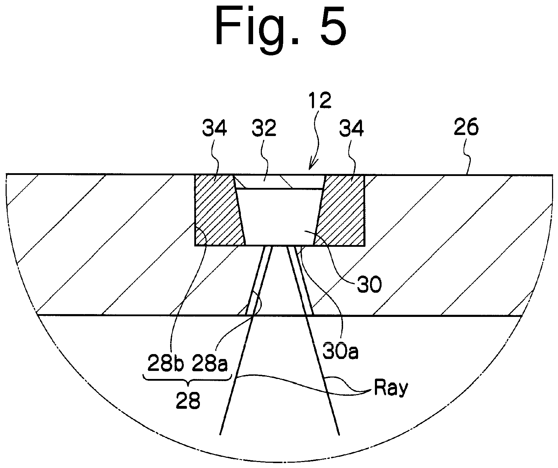

Fig. 5 is an enlarged view showing an area near the through hole 28 according to a modification. As shown in Fig. 3, the small diameter portion 28a can be a tapered opening with a diameter gradually increasing toward lower side. With this configuration, the excitation light Ray that is emitted from the excitation light source 14 and condensed by the condenser lens 16 can be prevented from being shielded by the small diameter portion 28a, thereby allowing the excitation light Ray to be effectively incident on the diffusion layer 30 (the lower face 30a thereof).

The wavelength conversion member 12 can be inserted into the large diameter portion 28b, and be fixed to the first holder 18 by any known means such as a transparent adhesive (for example, silicone-based adhesives, low melting point glass, and the like).

As shown in Fig. 4 (Fig. 5), the wavelength conversion member 12 can include the diffusion layer 30 and the wavelength conversion layer 32. The side face of the wavelength conversion member 12, or the side face 30c of the diffusion layer 30 and the side face 32c of the wavelength conversion layer 32, can be surrounded by the inner wall of the large diameter portion 28b.

The diffusion layer 30 can be a rectangular plate-like layer having a lower face 30a in surface contact with the step portion 28c (reflection film 28d) and an upper face 30b opposite thereto. The rectangular plate-like layer may have a size of 0.4 mm × 0.8 mm × 300 to 400 µm (thickness), for example.

The small diameter portion 28a of the through hole 28 can be smaller than the diameter of the diffusion layer 30 of the wavelength conversion member 12 so that the lower face 30a of the diffusion layer 30 is in surface contact with the step portion 28c. This can facilitate the heat dissipation from the wavelength conversion member 12 to the first holder 18.

The diffusion layer 30 and the wavelength conversion layer 32 can be fixed (bonded) so that the upper face 30b of the diffusion layer 30 and the lower face 32a of the wavelength conversion layer 32 are in surface contact with each other. In this configuration, the center area of the lower face 30a of the diffusion layer 30 is exposed from the small diameter portion 28a and the upper face 32b of the wavelength conversion layer 32 is exposed from the large diameter portion 28b.

The area of the lower face 30a of the diffused layer 30 which is exposed from the small diameter portion 28a is preferably subjected to an anti-reflection treatment such as an AR coating. With this configuration, the excitation light Ray that is emitted from the excitation light source 14 and condensed by the condenser lens 16 can be effectively caused to impinge on the lower face 30a of the diffusion layer 30.

The diffusion layer 30 can be formed from any material as long as the diffusion layer 30 can diffuse the excitation light entering through the lower face 30a so that the light can exit through the upper face 30b as diffused light. For example, the diffusion layer 30 may be a layer formed from a composite material (for example, sintered body) composed of alumina (for example, 75% Al₂O₃) and YAG (for example, 25%) without an activator agent such as cerium (also called as an emission center) introduced thereinto, a layer formed from a composite material composed of YAG and glass, a layer formed from alumina (or glass) in which air bubbles are dispersed, or any other similar material. Note that the diffusion layer 30 is desirably formed from a material having a higher heat conductivity (for example, alumina being better than glass) from the viewpoint of improved heat dissipation property.

In the present exemplary embodiment, the diffusion layer 30 may be a rectangular plate-like layer having a size of 0.4 mm × 0.8 mm × 300 to 400 µm (thickness) and formed from a composite material composed of alumina (for example, 75% Al₂O₃) and YAG (for example, 25%) without an activator agent such as cerium introduced thereinto.

The diffusion layer 30 is not limited to be a rectangular plate shape, but may be a cylinder with a diameter of 0.4 to 0.8 mm, a rectangular parallelpiped with a short side of 0.3 to 0.6 mm and a long side of 0.6 to 2.0 mm.

The present inventor has confirmed that the thicker diffusion layer 30 can suppress or prevent the brightness unevenness of diffused light exiting through the upper face 30b of the diffusion layer 30 without generating the brightness distribution having a local peak portion.

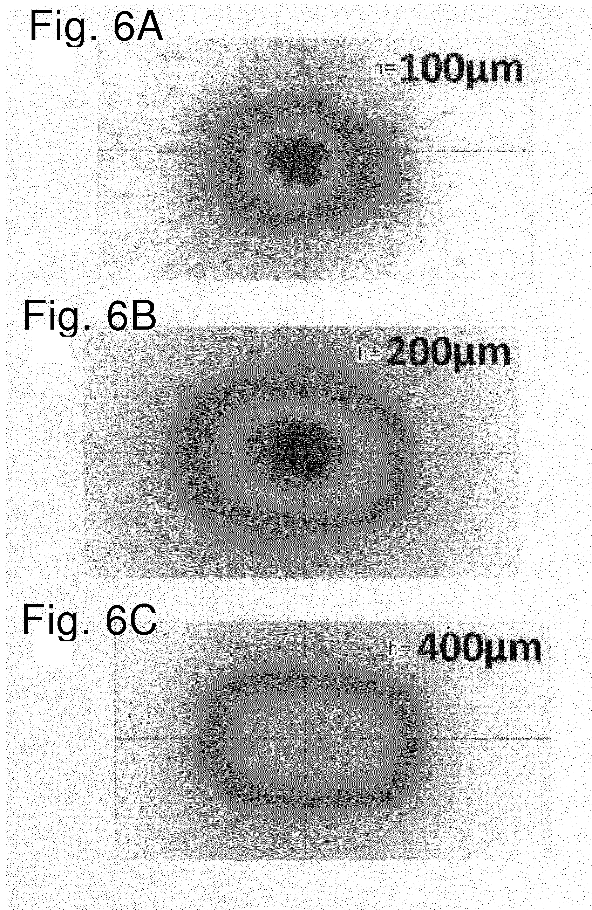

Figs. 6A, 6B, and 6C are each a brightness distribution of diffused light exiting through the upper face 30b of a diffusion layer 30 (being a diffusion plate) when the center of the lower face 30a of the diffusion layer 30 with a different thickness h is irradiated with the equivalent excitation light collected by the condenser lens 16 in a spotlight manner. In the present exemplary embodiment, the diffusion layer 30 used is a rectangular plate-like layer having a size of 0.4 mm × 0.8 mm and formed from a composite material composed of alumina (75%) and YAG (25%) without an activator agent such as cerium introduced thereinto. Furthermore, the spot size of excitation light collected by the condenser lens 16 is adjusted to be oval with a long axis of about 100 µm and a short axis of about 20 µm to 30 µm. The side faces of the diffusion layer 30 can be covered with a curable reflective material 34.

With reference to Figs. 6A to 6C, as the thickness h of the diffusion layer 30 increases from 100 µm (Fig. 6A) via 200 µm (Fig. 6B) to 400 µm (Fig. 6C), the brightness unevenness is gradually suppressed or prevented. As shown in Fig. 6C, when the thickness h is 400 µm, it can be seen that the brightness distribution can be even or substantially even. This is because when the thickness h of the diffusion layer 30 increases, the number of times for diffusion of excitation light and light emitted by the excitation light collected by the condenser lens 16 and diffused within the diffusion layer 30 (or the number of times for diffusion due to the difference of refraction indexes between YAG and alumina) increases and the light can be evened. The thus evened excitation light and emission light by the excitation light can be projected from the upper face 30b of the diffusion layer 30.

As described above, the increased thickness h of the diffusion layer 30 can suppress or prevent the brightness unevenness of the diffused light projected from the upper face 30b of the diffusion layer 30, thereby preventing the local brightened area in the brightness distribution from being produced.

Based on the above-described findings, the thickness h of the diffusion layer 30 can be set to values at which the diffused light projected from the upper face 30b of the diffusion layer 30 can have a brightness distribution without a local peak portion being produced. In the present exemplary embodiment, the thickness h is set to fall within a range of 300 µm to 500 µm. In the present exemplary embodiment, the wavelength conversion layer 32, as shown in Fig. 4, may be a rectangular plate-like layer including a lower face 32a in surface contact with the upper face 30b of the diffusion layer 30 and an upper face 32b opposed thereto and having a size of 0.4 mm × 0.8 mm × 80 µm (thickness), for example.

The wavelength conversion layer 32 can be formed from a phosphor, and the material therefor is not particularly limited as long as the layer can be excited by the excitation light incident on the lower face 32a thereof to emit wavelength converted light through the upper face 32b. For example, the wavelength conversion layer 32 can be a layer formed from a composite material composed of alumina (Al₂O₃) and YAG with an activator agent such as cerium introduced thereinto, or a layer formed from a composite material composed of YAG and a glass binder with an activator agent such as cerium introduced thereinto.

In the present exemplary embodiment, the wavelength conversion layer 32 used is a rectangular plate-like layer having a size of 0.4 mm × 0.8 mm × 80 µm (thickness), formed from a composite material composed of alumina (Al₂O₃) and YAG with an activator agent such as cerium introduced thereinto. The thickness of the wavelength conversion layer 32 can preferably be set to fall within a range of 50 µm to 200 µm.

Note that the shape of the wavelength conversion layer 32 is not limited to a rectangular-plate shape, but may be a cylinder with a diameter φ of 0.4 mm to 0.8 mm, a parallelpiped shape with a short side of 0.3 mm to 0.6 mm and a long side of 0.6 mm to 2.0 mm, etc.

The diffusion layer 30 and the wavelength conversion layer 32 can be fixed (bonded) to each other so as to be in surface contact with each other with the upper face 30b of the diffusion layer 30 and the lower face 32a of the wavelength conversion layer 32 being in surface contact with each other. For example, if both the diffusion layer 30 and the wavelength conversion layer 32 are made of ceramics, they can be bonded to each other by heating them at high temperatures for curing while the upper face 30b of the diffusion layer 30 and the lower face 32a of the wavelength conversion layer 32 are in surface contact with each other. If the wavelength conversion layer 32 is a glass phosphor layer, they can be bonded to each other by curing them under certain conditions while the upper face 30b of the diffusion layer 30 and the lower face 32a of the wavelength conversion layer 32 are in surface contact with each other.

When the wavelength conversion member 12 is made of ceramics, processing tolerance may occur due to its production method, thereby causing difficulty in producing the member 12 to have a dimension in close contact with the housing (first holder 18). In this case, a gap S can be generated between the side face of the wavelength conversion member 12 (or the side face 30c of the diffusion layer 30 and the side face 32c of the wavelength conversion layer 32) and the inner wall of the large diameter portion 28b, as shown in Fig. 4.

The gap S can be filled with a curable reflective material 34, which can be a molding material containing titanium oxide, alumina, Ag, or the like, for example. This can improve the light extraction efficiency. This may be because the side faces of the wavelength conversion member 12 can be covered with the curable reflective material 34 filled in the gap S, and thereby the light that is to exit through the side faces of the wavelength conversion member 12 can be reflected by the reflective material 34 and re-enter the wavelength conversion member 12. As a result, when comparing the case where the curable reflective material 34 is not filled, the light extraction efficiency can be improved.

Furthermore, the light utilization efficiency can be improved. This may be because the curable reflective material 34 filled in the gap S can strengthen the adhesion between the wavelength conversion layer 32 and the metal housing (first holder 18), and as a result, the heat dissipation from the side face of the wavelength conversion layer 12 to the first holder 18 can be facilitated. Accordingly, when comparing with the case where the curable reflective material is not filled, the light utilization efficiency can be improved.

The second holder 20 can be a member for holding the first holder 18, and include a metal cylindrical portion 20a made of stainless steel or aluminum.

The lower part of the first holder 18 can be fitted to the upper part of the second holder 20. The first holder 18 and the second holder 20 can be fixed in the following manner, for example.

First, the first holder 18 is moved in the optical axis AX₁₀ direction (Z direction) with respect to the second holder 20. In this case, the first holder 18 should be positioned such that the excitation light emitted from the excitation light source 14 and collected by the condenser lens 16 is not deviated from the optical axis AX₁₀ direction and the wavelength conversion member 12 (the lower face 30a of the diffusion layer 30) can be illuminated with the light in a spotlight manner with high accuracy. Then, while this state is maintained, the first holder 18 and the second holder 20 are fixed to each other by known means such as YAG welding, an adhesive, etc.

The third holder 22 can be a member for holding the second holder 20, the excitation light source 14, and the condenser lens 16. The third holder 22 can include a metal cylinder portion 36 made of stainless steel or aluminum, for example, a flange portion 38 provided around the lower outer peripheral of the cylinder portion 36, and an upper face 40 partly closing the upper opening end of the cylinder portion 36. The upper face 40 can include a through hole 42 penetrating therethrough in the thickness direction at the center thereof. The through hole can serve as a light path through which the excitation light from the excitation light source can pass. The condenser lens 16 can be inserted into the through hole 42 and fixed to the third holder 22 by known means such as an adhesive.

The excitation light source 14 can be fixed to the third holder 22 by known means such as an adhesive or welding while the light source 14 is kept facing to the lower opening end of the through hole 42 where the condenser lens 16 is positioned.

The excitation light source 14 can preferably be a semiconductor light emitting element such as a light emitting diode (LED) or a laser diode (LD), and in particular preferably an LD in view of the better light utilization efficiency. When an LD having a higher light density than an LED is utilized, a white light source (light emitting device) with higher brightness can be implemented. In the present exemplary embodiment, an LD having a light emission wavelength of about 450 nm is used as the excitation light source 14. The emission wavelength of the excitation light source 14 can be a near-ultraviolet range (for example, around 405 nm) other than the wavelength of 450 nm. In this case, the wavelength conversion layer 32 can include phosphors with three different emission colors of blue, green, and red or with two different emission colors of blue and yellow.

The second holder 20 and the third holder can be fixed in the following manner.

First, the second holder 20 is moved in the X and Y directions with respect to the third holder 22 while the lower opening end of the second holder 20 is in contact with the upper face 40 of the third holder 22. In this case, the second holder 20 should be positioned such that the excitation light emitted from the excitation light source 14 and collected by the condenser lens 16 is not deviated in the X and Y directions and the wavelength conversion member 12 (the lower face 30a of the diffusion layer 30) can be illuminated with the light in a spotlight manner with high accuracy. Then, while this state is maintained, the second holder 20 and the third holder 22 are fixed to each other by known means such as YAG welding, an adhesive, etc.

According to the light emitting device 10 with the above configuration, the excitation light emitted from the excitation light source 14 and collected by the condenser lens 16 is not deviated in the X and Y directions and also the Z direction and the wavelength conversion member 12 (the lower face 30a of the diffusion layer 30) can be illuminated with the light in a spotlight manner with high accuracy. As a result of this, the light output from the wavelength conversion member 12 can be maximized.

In the light emitting device 10 with the above configuration, the excitation light from the excitation light source 14 can be collected by the condenser lens 16 and pass through the through hole 28 (small diameter portion 28a) and be projected onto the center of the lower face 30a of the diffusion layer 30 of the wavelength conversion member 12 placed away from the excitation light source 14 in a spotlight manner. In this case, the spot size of excitation light can be adjusted to be oval with a long axis of about 100 µm and a short axis of about 20 µm to 30 µm. The excitation light incident on the center of the lower face 30a of the diffusion layer 30 can be diffused inside of the diffusion layer 30 to be projected through the upper face 30b of the diffusion layer 30 as diffused light having a brightness distribution without a local peak portion being produced. Then, the diffused light can be incident on the lower face 32a of the wavelength conversion layer 32 as shown in Fig. 4.

The wavelength conversion layer 32 where the diffused light is incident can be excited by part of the excitation light to emit light as wavelength converted light. The remaining part of the excitation light and the emission light can be mixed together to produce white light (pseud white light) .

The light emitting device 10 with the above configuration can generate the following advantageous effects.

First, the brightness saturation or temperature quenching can be remedied, which conventionally occurs when high density laser light is collected for spot illumination. This can prevent the efficiency due to the local brightness saturation or temperature quenching from being decreased. This may be because the excitation light from the excitation light source 14 is incident on the wavelength conversion layer 32 not as light collected by optical system (such as a condenser lens) in a spotlight manner as in the conventional cases, but as diffused light sufficiently diffused by the diffusion layer 30 and having the brightness distribution without a local peak portion being produced.

Second, color unevenness can be suppressed or prevented. This may also be because the excitation light from the excitation light source 14 is incident on the wavelength conversion layer 32 not as light collected by optical system (such as a condenser lens) in a spotlight manner as in the conventional cases, but as diffused light sufficiently diffused by the diffusion layer 30 and having the brightness distribution without a local peak portion being produced.

Third, the light extraction efficiency can be improved, thereby enabling the production of high efficiency device. This may be because the color unevenness is suppressed or prevented by the use of the diffusion layer 30, thereby enabling the thinning of the wavelength conversion layer 32. If the color unevenness is tried to be suppressed or prevented by diffusing the excitation light from the excitation light source 14 without the diffusion layer 30, the wavelength conversion layer 32 should have a certain thickness, resulting in diffusion of excited emission light within the wavelength conversion layer 32. This may lead to lowering of the light extraction efficiency.

Fourth, the light extraction efficiency can be further improved by the action of the reflection film 28d made of Ag or Al formed on the step portion 28c. This may be because an area of the lower face 30a of the diffusion layer 30 other than the area illuminated with the excitation light emitted from the excitation light source 14 and collected by the condenser lens 16 can be covered with the reflection film 28d as shown in Fig. 4, and the light directed to and exiting through the lower face 30a of the diffusion layer 30 can be reflected by the reflection film 28d to re-enter the diffusion layer 30.

Fifth, the light extraction efficiency can be improved by the action of the curable reflective material 34. This may be because the side faces of the wavelength conversion member 12 including the side face 30c of the diffusion layer 30 and the side face 32c of the wavelength conversion layer 32 can be covered with the curable reflective material 34 as shown in Fig. 4, and thereby the light that is to exit through the side faces of the wavelength conversion member 12 can be reflected by the reflective material 34 and re-enter the wavelength conversion member 12.

Next, a description will be given of a modification.

As shown in Fig. 5, the diffusion layer 30 can be a tapered layer having a gradually small diameter toward its lower portion. By configuring so, the excitation light diffused by the diffusion layer 30 and directed sideward can be reflected by the curable reflective material 34 toward the upper face 30b, resulting in an improvement in the light extraction efficiency.

The side face of the wavelength conversion member 12 including the side face 30c of the diffusion layer 30 and the side face 32c of the wavelength conversion layer 32 can be covered by a reflection film produced by vapor deposition of Ag or Al. By doing so, the light extraction efficiency can be further improved.

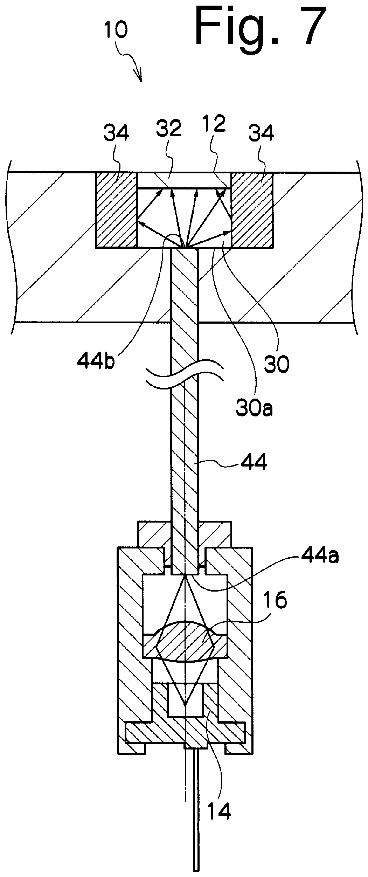

Fig. 7 is a cross-sectional view of a light emitting device 10 according to a modification.

In this modification, as the optical system that can collect the excitation light emitted from the excitation light source 14 and irradiate the lower face 30a of the diffusion layer 30 with light in a spotlight manner, the condenser lens 16 itself can be replaced with an optical system. The present optical system can include: a condenser lens 16 for collecting the excitation light emitted from the excitation light source 14; and a light guide 44 for guiding the collected excitation light so as to irradiate the lower face 30a of the diffusion layer 30 with light in a spotlight manner. The light guide 44 can be formed from an optical fiber including a center core (with a core diameter of 0.2 mm, for example) and a clad surrounding the core (which are not shown). The optical fiber can be designed so that the core has a higher refractive index than the clad. The excitation light emitted from the excitation light source 14 and collected by the condenser lens 16 can enter the light guide 44 through one end face 44a thereof and be guided by the same while being totally reflected by the interfacial surface between the core and the clad and enclosed within the core to the other end face 44b of the light guide 44. Then, the light can be projected through the end face 44b of the light guide 44 and be incident on the center of the lower face 30a of the diffusion layer 30 of the wavelength conversion member 12 placed away from the excitation light source 14 in a spotlight manner.

The excitation light incident on the center of the lower face 30a of the diffusion layer 30 can be diffused inside of the diffusion layer 30 to be projected through the upper face 30b of the diffusion layer 30 as diffused light having a brightness distribution without a local peak portion being produced. Then, the diffused light can be incident on the lower face 32a of the wavelength conversion layer 32.

The wavelength conversion layer 32 where the diffused light is incident can be excited by part of the excitation light to emit light as wavelength converted light. The remaining part of the excitation light and the emission light can be mixed together to produce white light (pseud white light).

According to the above modification, the same advantageous effects described in the above-mentioned exemplary embodiment can also be achieved.

Next, a description will be given of a vehicle lighting unit utilizing the light emitting device 10 with the above configuration.

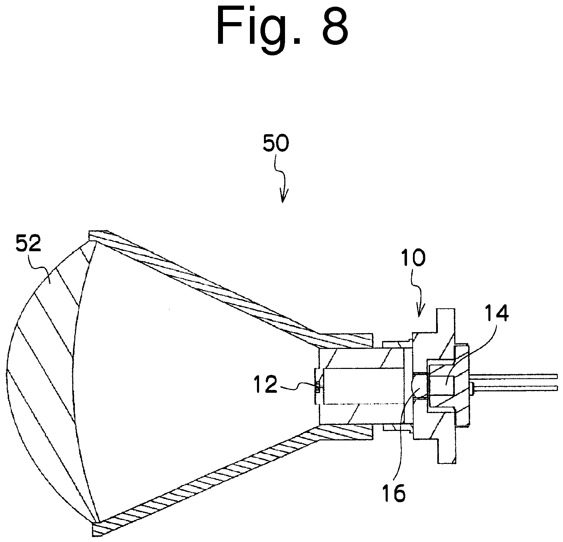

Fig. 8 is sectional view showing a configuration example of a direct projection type vehicle lighting unit 50 including a projection lens 52 serving as an optical system configured to illuminate a front area of a vehicle body with light. The projection lens 52 and the light emitting device 10 can be held by a holder 54 so as to provide a predetermined positional relation.

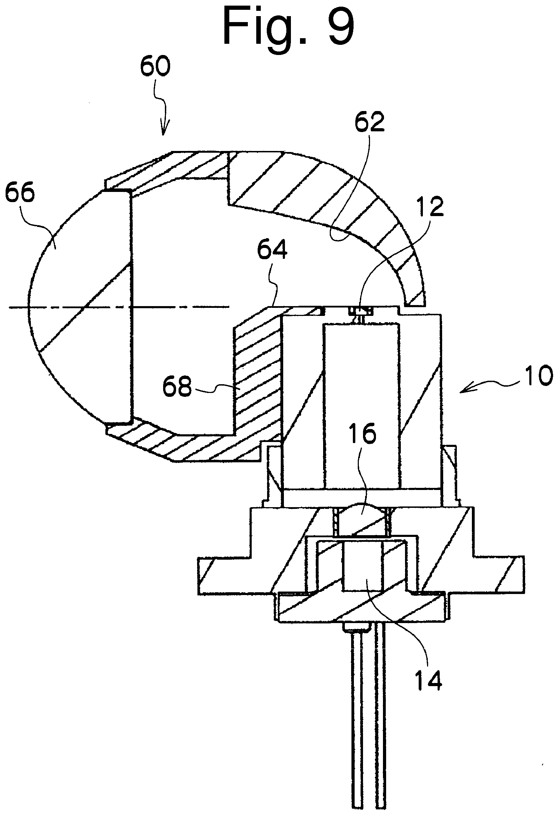

Fig. 9 is a sectional view of a projector type vehicle lighting unit 60 including a reflection face 62, a shade 64 and a projection lens 66 which can constitute an optical system configured to illuminate a front area of a vehicle body with light. The reflection face 62, the shade 64, and the projection lens 66 can be held by a holder 68 so as to provide a predetermined positional relation.

With the vehicle lighting units 50 and 60 each utilizing the high brightness light emitting device 10 as a light source, the miniaturization of the vehicle lighting unit itself and the improvement in far distance visibility can be enhanced. Furthermore, when a plurality of optical units are combined with the vehicle lighting unit 50, 60 to constitute a vehicle headlight, the vehicle lighting unit 50, 60 can be configured to form a spot light distribution. This can enhance the far distance visibility.

## Claims

1. A light emitting device (10) comprising:
an excitation light source (14) for emitting excitation light;
a wavelength conversion member (12) including a diffusion layer (30) and a wavelength conversion layer (32), the diffusion layer (30) having a first face (30a) and a second face (30b) opposite to the first face (30a), the diffusion layer (30) configured to diffuse excitation light that is irradiated onto the first face (30a) and cause the diffused light to exit through the second face (30b), the wavelength conversion layer (32) having a third face (32a) in contact with the second face (30b) and a fourth face (32b) opposite to the third face (32a), the wavelength conversion layer (32) configured to convert the excitation light incident on the third face (32a) in wavelength and cause the wavelength-converted light to exit through the fourth face (32b); and
an optical system (16, 44) configured to collect the excitation light from the excitation light source (14) to irradiate the first face (30a) with the collected excitation light in a spotlight manner,
**characterized by**
a holder (18) including a metal cylindrical tube portion (24) and configured to hold the wavelength conversion member (12),
wherein
the holder (18) includes a through hole (28) having a small diameter portion (28a), which is smaller than the diffusion layer (30), on the side closer to the optical system (16, 44) and a large diameter portion (28b) opposite thereto with a step portion (28c) between the small diameter portion (28a) and the large diameter portion (28b),
the diffusion layer (30) is supported by the step portion (28c) so that the first face (30a) is in surface contact with the step portion (28c),
the wavelength conversion layer (32) is supported by the diffusion layer (30) to be in surface contact with the diffusion layer (30) so that the fourth face (32b) of the wavelength conversion layer (32) is exposed from the large diameter portion (28b),
a gap (S) between the side face (30c) of the diffusion layer (30) and the inner wall of the large diameter portion (28b) and between the side face (32c) of the wavelength conversion layer (32) and the inner wall of the large diameter portion (28b) is filled with a curable reflective material (34),
the diffusion layer (30) is formed from a composite material composed from alumina and YAG without an activator agent introduced thereinto; and
the diffusion layer (30) has a thickness of 300 *µ*m to 500 *µ*m that is set in such a manner that brightness distribution of the diffused light exiting through the second face (30b) does not include a local peak.

2. The light emitting device (10) according to claim 1, **characterized by** further comprising a first reflection member (28d) configured to cover an area of the first face (30a) that is not irradiated with the excitation light that is emitted from the excitation light source 14 and collected by the optical system (16, 44).

3. The light emitting device (10) according to claim 1 or 2, **characterized in that** side faces (30c, 32c) of the wavelength conversion member (12) are covered with a second reflection member (34).

4. The light emitting device (10) according to any one of claims 1 to 3, **characterized in that** the optical system (16, 44) includes a condenser lens (16) configured to collect the excitation light from the excitation light source (14) to irradiate the center of the first face (30a) with the collected excitation light in a spotlight manner.

5. The light emitting device (10) according to any one of claims 1 to 4, **characterized in that** the optical system (16, 44) includes a condenser lens (16) configured to collect the excitation light from the excitation light source (14) and a light guide (44) configured to guide the excitation light collected by the condenser lens (16) to irradiate the center of the first face (30a) with the collected excitation light in a spotlight manner.

6. A vehicle lighting unit comprising:
a light emitting device (10) as set forth in any of the preceding claims, and
a vehicular optical system (52, 62, 64, 66) configured to control light from the light emitting device (10) to illuminate a front area of a vehicle body where the vehicle lighting unit is installed.

## Patentansprüche

1. Leuchteinrichtung (10), die Folgendes aufweist:
eine Erregungslichtquelle (14) zum Emittieren von Erregungslicht;
ein Wellenlängenumwandlungsglied (12), das eine Diffusionsschicht (30) und eine Wellenlängenumwandlungsschicht (32) aufweist, wobei die Diffusionsschicht (30) eine erste Fläche (30a) und eine zweite Fläche (30b) gegenüberliegend der ersten Fläche (30a) aufweist, wobei die Diffusionsschicht (30) konfiguriert ist, um das Erregungslicht zu streuen, das auf die erste Fläche (30a) ausgestrahlt wird, und um zu veranlassen, dass das gestreute Licht durch die zweite Fläche (30b) austritt, wobei die Wellenlängenumwandlungsschicht (32) eine dritte Fläche (32a) aufweist, die sich in Kontakt mit der zweiten Fläche (30b) befindet, sowie eine vierte Fläche (32b), die der dritten Fläche (32a) gegenüber liegt, wobei die Wellenlängenumwandlungsschicht (32) konfiguriert ist, um das Erregungslicht, das auf die dritte Fläche (32a) fällt, in der Wellenlänge umzuwandeln und bewirkt, dass das in der Wellenlänge umgewandelte Licht durch die vierte Fläche (32b) austritt; und
ein optisches System (16, 44), das konfiguriert ist, um das Erregungslicht von der Erregungslichtquelle (14) zu sammeln, um die erste Fläche (30a) mit dem gesammelten Erregungslicht in einer Art eines Schweinwerfers auszustrahlen,
**gekennzeichnet durch**
eine Haltevorrichtung (18), die einen zylindrischen Metallrohrteil (24) aufweist, und konfiguriert ist, um das Wellenlängenumwandlungsglied (12) zu halten,
wobei
die Haltevorrichtung (18) ein Durchgangsloch (28) mit einem Teil (28a) mit kleinem Durchmesser, der kleiner als die Diffusionsschicht (30) ist, auf der Seite, die näher an dem optischen System (16, 44) ist, und einen Teil (28b) mit großem Durchmesser gegenüberliegend dazu aufweist, mit einem Stufenteil (28c) zwischen dem Teil (28a) mit kleinem Durchmesser und dem Teil (28b) mit großem Durchmesser,
die Diffusionsschicht (30) durch den Stufenteil (28c) getragen wird, so dass sich die erste Fläche (30a) in Oberflächenkontakt mit dem Stufenteil (28c) befindet,
die Wellenlängenumwandlungsschicht (32) durch die Diffusionsschicht (30) getragen wird, damit sie sich in Oberflächenkontakt mit der Diffusionsschicht (30) befindet, so dass die vierte Fläche (32b) der Wellenlängenumwandlungsschicht (32) von dem Teil (28b) mit großem Durchmesser exponiert bzw. freigelegt ist,
ein Spalt (S) zwischen der Seitenfläche (30c) der Diffusionsschicht (30) und der Innenwand des Teils (28b) mit großem Durchmesser und zwischen der Seitenfläche (32c) der Wellenlängenumwandlungsschicht (32) und der Innenwand des Teils (28b) mit großem Durchmesser mit einem aushärtbarem, reflektierenden Material (34) gefüllt ist,
die Diffusionsschicht (30) aus einem Verbundmaterial gebildet ist, das aus Aluminiumoxid und YAG ohne einen darin eingeführten Aktivierungswirkstoff besteht; und
die Diffusionsschicht (30) eine Dicke von 300 µm bis 500 µm aufweist, die in einer solchen Art und Weise eingestellt ist, dass die Helligkeitsverteilung des gestreuten Lichts, das durch die zweite Fläche (30b) austritt, keine lokale Spitze aufweist.

2. Leuchteinrichtung (10) gemäß Anspruch 1, **dadurch gekennzeichnet, dass** sie ferner ein erstes Reflexionsglied (28d) aufweist, das konfiguriert ist, um einen Bereich der ersten Fläche (30a) abzudecken, der nicht mit dem Erregungslicht bestrahlt wird, das von der Erregungslichtquelle 14 emittiert und durch das optische System (16, 44) gesammelt wird.

3. Leuchteinrichtung (10) gemäß Anspruch 1 oder 2, **dadurch gekennzeichnet, dass** die Seitenflächen (30c, 32c) des Wellenlängenumwandlungsglieds (12) mit einem zweiten Reflexionsglied (34) abgedeckt sind.

4. Leuchteinrichtung (10) gemäß einem der Ansprüche 1 bis 3, **dadurch gekennzeichnet, dass** das optische System (16, 44) eine Kondensator- bzw. Sammellinse (16) aufweist, die konfiguriert ist, um das Erregungslicht von der Erregungslichtquelle (14) zu sammeln, um die Mitte der ersten Fläche (30a) mit dem gesammelten Erregungslicht in einer Art eines Scheinwerfers zu bestrahlen.

5. Leuchteinrichtung (10) gemäß einem der Ansprüche 1 bis 4, **dadurch gekennzeichnet, dass** das optische System (16, 44) eine Sammellinse (16) aufweist, die konfiguriert ist, um das Erregungslicht von der Erregungslichtquelle (14) zu sammeln, sowie eine Lichtführung (44), die konfiguriert ist, um das Erregungslicht zu führen, das durch die Sammellinse (16) gesammelt wird, um die Mitte der ersten Fläche (30a) mit dem gesammelten Erregungslicht in einer Art eines Scheinwerfers zu bestrahlen.

6. Fahrzeugbeleuchtungseinheit, die Folgendes aufweist:
eine Leuchteinrichtung (10) gemäß einem der vorangehenden Ansprüche, und
ein Fahrzeugoptiksystem (52, 62, 64, 66), das konfiguriert ist, um das Licht von der Leuchteinrichtung (10) zu steuern, um einen vorderen Bereich eines Fahrzeugkörpers zu beleuchten, wo die Fahrzeugbeleuchtungseinheit installiert ist.

## Revendications

1. Dispositif électroluminescent (10) comprenant :
une source de lumière d'excitation (14) pour émettre de la lumière d'excitation ;
un élément de conversion de longueur d'onde (12) comprenant une couche de diffusion (30) et une couche de conversion de longueur d'onde (32), la couche de diffusion (30) ayant une première face (30a) et une deuxième face (30b) opposée à la première face (30a), la couche de diffusion (30) étant agencée pour diffuser de la lumière d'excitation qui est irradiée vers la première face (30a) et amener la lumière diffusée à sortir par la deuxième face (30b) , la couche de conversion de longueur d'onde (32) comportant une troisième face (32a) en contact avec la deuxième face (30b) et une quatrième face (32b) opposée à la troisième face (32a), la couche de conversion de longueur d'onde (32) étant agencée pour convertir en longueur d'onde la lumière d'excitation incidente sur la troisième face (32a) et amener la lumière convertie en longueur d'onde à sortir par la quatrième face (32b) ; et
un système optique (16, 44) agencé pour recueillir la lumière d'excitation à partir de la source de lumière d'excitation (14) pour irradier la première face (30a) avec la lumière d'excitation recueillie d'une manière comparable à un spot lumineux,
**caractérisé par**
un support (18) comprenant une portion en tube cylindrique métallique (24) et agencé pour tenir l'élément de conversion de longueur d'onde (12),
dans lequel le support (18) comprend un trou traversant (28) ayant une portion de petit diamètre (28a), qui est plus petite que la couche de diffusion (30), sur le côté plus proche du système optique (16, 44), et une portion de grand diamètre (28b) opposée, avec une portion en échelon (28c) entre la portion de petit diamètre (28a) et la portion de grand diamètre (28b),
la couche de diffusion (30) est supportée par la portion en échelon (28c) de sorte que la première face (30a) est en contact de surface avec la portion en échelon (28c),
la couche de conversion de longueur d'onde (32) est supportée par la couche de diffusion (30) pour être en contact de surface avec la couche de diffusion (30) de sorte que la quatrième face (32b) de la couche de conversion de longueur d'onde (32) est exposée à partir de la portion de grand diamètre (28b),
un intervalle (S) entre la face latérale (30c) de la couche de diffusion (30) et la paroi intérieure de la portion de grand diamètre (28b) et entre la face latérale (32c) de la couche de conversion de longueur d'onde (32) et la paroi intérieure de la portion de grand diamètre (28b) est rempli d'un matériau réfléchissant durcissable (34),
la couche de diffusion (30) est formée en un matériau composite composé d'alumine et de YAG sans qu'un agent activateur ne soit introduit dedans ; et
la couche de diffusion (30) a une épaisseur de 300 µm à 500 µm qui est réglée de telle sorte que la distribution d'intensité lumineuse de la lumière diffusée sortant par la deuxième face (30b) ne comprend pas de pic local.

2. Dispositif électroluminescent (10) selon la revendication 1, **caractérisé en ce qu'**il comprend en outre un premier élément de réflexion (28d) agencé pour couvrir une région de la première face (30a) qui n'est pas irradiée par la lumière d'excitation qui est émise par la source de lumière d'excitation 14 et recueillie par le système optique (16, 44).

3. Dispositif électroluminescent (10) selon la revendication 1 ou 2, **caractérisé en ce que** des faces latérales (30c, 32c) de l'élément de conversion de longueur d'onde (12) sont recouvertes d'un deuxième élément de réflexion (34).

4. Dispositif électroluminescent (10) selon l'une quelconque des revendications 1 à 3, **caractérisé en ce que** le système optique (16, 44) comprend une lentille de condenseur (16) agencée pour recueillir la lumière d'excitation provenant de la source de lumière d'excitation (14) pour irradier le centre de la première face (30a) avec la lumière d'excitation recueillie d'une manière similaire à un spot lumineux.

5. Dispositif électroluminescent (10) selon l'une quelconque des revendications 1 à 4, **caractérisé en ce que** le système optique (16, 44) comprend une lentille de condenseur (16) agencée pour recueillir la lumière d'excitation provenant de la source de lumière d'excitation (14) et un guide de lumière (44) agencé pour guider la lumière d'excitation recueillie par la lentille de condenseur (16) pour irradier le centre de la première face (30a) avec la lumière d'excitation recueillie d'une manière similaire à un spot lumineux.

6. Bloc d'éclairage de véhicule comprenant :
un dispositif électroluminescent (10) selon l'une quelconque des revendications précédentes, et
un système optique véhiculaire (52, 62, 64, 66) agencé pour contrôler la lumière provenant du dispositif électroluminescent (10) pour éclairer une région à l'avant d'une carrosserie de véhicule dans laquelle le bloc d'éclairage de véhicule est installé.
